# EUROPÄISCHE PATENTSCHRIFT

(11) **EP 1 328 965 B1**
(45) Veröffentlichungstag und Bekanntmachung des Hinweises auf die Patenterteilung: **17.12.2008**
(21) Anmeldenummer: 01988943.5
(22) Anmeldetag: 24.10.2001
(51) Int. Cl.: H01L 21/00

(54) **BEHANDLUNGSEINRICHTUNG FÜR WAFER**
TREATMENT DEVICE FOR WAFERS
DISPOSITIF DE TRAITEMENT DE PLAQUETTES

(30) Priorität: 24.10.2000 DE 10052724
(43) Veröffentlichungstag der Anmeldung: 23.07.2003
(73) Patentinhaber: Pac Tech - Packaging Technologies GmbH, 14641 Nauen (DE)
(72) Erfinder: TEUTSCH, Thorsten, Pac Tech-Packaging Tech. GmbH, 14641 Nauen (DE); ZAKEL, Elke, 14612 Falkensee (DE)
(74) Vertreter: Leonhard, Frank Reimund
(86) Internationale Anmeldenummer: PCT/DE2001/004036
(87) Internationale Veröffentlichungsnummer: WO 2002/035582

(56) Entgegenhaltungen:
- EP-A- 0 343 502
- WO-A-99/60184
- US-A- 5 800 623
- US-A- 5 853 483
- PATENT ABSTRACTS OF JAPAN vol. 1999, no. 10, 31. August 1999 (1999-08-31) & JP 11 145149 A (DAINIPPON SCREEN MFG CO LTD), 28. Mai 1999 (1999-05-28)
- PATENT ABSTRACTS OF JAPAN vol. 013, no. 005 (E-701), 9. Januar 1989 (1989-01-09) & JP 63 216355 A (NIKON CORP), 8. September 1988 (1988-09-08)

## Beschreibung

Die Erfindung befaßt sich mit einer Behandlungsanordnung zur Reinigung oder Veraschung von Oberflächen. Es geht maßgeblich darum, Wafer hinsichtlich ihrer Beschaffenheit zu verändern, wobei die Oberfläche angesprochen ist. Die Oberfläche soll bearbeitet oder behandelt werden, worunter mit der Erfindung sowohl eine Reinigung, wie auch eine anderweitige - auch abschnittsweise - Bearbeitung der Oberfläche gemeint ist.

Im Stand der Technik sind Bearbeitungseinrichtungen für solche Wafer vorgesehen, bei denen die Wafer auf metallische Platten aufgelegt werden und dann mit einem Plasma oder einem reaktiven Ionenätzen (RIE) bearbeitet werden, vgl. JP-A 57-070278 (NEC). Die Wafer nehmen dadurch zu oft Schaden, insbesondere durch das mechanische Aufliegen auf den metallischen Basisplatten, wobei das Auftreten von Lackkratzern und sonstige mechanischen Kratzern der empfindlichen Oberfläche nicht ausgeschlossen werden kann.

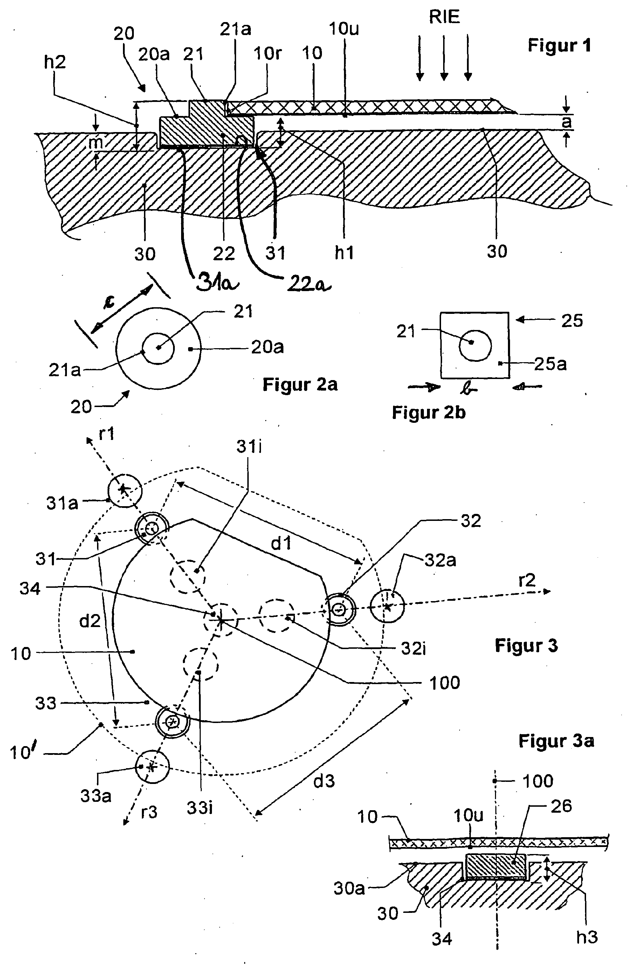

Aus der US-A 5,044,871 (Davies) ist eine Halteanordnung für Wafer dem Fachmann zugänglich, die in der dortigen Figur 3 zu den Tragstücken 50 und der zugehörigen Beschreibung in Spalte 10, Zeile 55 bis Spalte 11, Zeile 16, "Pins" (dort 50) beschreibt, die säulenförmig und beweglich zum Transport der Wafer gestaltet sind. Eine nähere Erläuterung dieser säulenförmigen Tragstücke ist auch der dort referenzierten Schrift US-A 4,659,413 (Davies) nicht zu entnehmen, allenfalls in der dortigen Figur 13 sind Tragstücke (dort 155) vorgesehen, die nicht in Mulden sitzen. Sie werden als "Centering Pins" beschrieben, vgl. dort Spalte 11, Zeilen 8 bis 54, insbesondere Zeilen 35 bis 42. Schließlich ist in der o.g. JP-A 57-070278 (NEC) eine Anordnung zum Stützen von Wafern beschrieben, die mit ebenfalls säulenförmigen Pins (dort 4) gestaltet ist, die über eine Federanordnung durch ein Bodenloch aufwärts verschiebbar und absenkbar sind, vgl. dort Abstract (Patent Abstracts of Japan). Die Pins werden dabei von einem unteren Ruhezustand in einen höheren Zustand versetzt, wobei die zunächst auf der Hauptplatte aufliegende Scheibe abgehoben, danach aber wieder auf die Platte abgesenkt und abgelegt wird. Durch das Ablegen wird bei beheizter Platte eine bessere Wärmeübertragung für den Plasmaprozess nach dortiger Aussage möglich. Die Pins werden nicht von oben in das Bodenloch eingesetzt, sondern von unten, um dann über eine Art Balgen (dort 6) von einem Stößel (dort 7) aufwärts und abwärts gegen eine Federkraft verschoben werden zu können, was beinhaltet, dass die vorgesehene Stufe im Pin auf der Höhe der Oberfläche der Hauptplatte zu liegen kommt, in welcher Position die Scheibe auf der Hauptplatte mit Kratzgefährdung aufliegt. Einen deutlichen Abstand von der Platte hält dagegen die Anordnung nach US-A 5,853,483 (Morita) mit der festgeschraubte Abstandshalter in einer Tragplatte (dort 4) vorgesehen sind, welche als Stützfüße für Waferscheiben dienen. Zur Planlage einer Waferscheibe werden Abstimmungen nötig, und das Auswechseln der einzelnen, jeweils für sich festgeschraubten Abstandhalter ist zeitaufwendig und dennoch ungenau im Höhenmaß. Schließlich zeigt die WO-A 99/60184 (Applied Materials) eine Anordnung, bei der nach den dortigen Figuren 3 und 9 säulenförmige Abstandshalter in Vertiefungen eingesetzt werden, um darauf aufliegend Waferscheiben beweglich zu lagern. Bei mechanischer Vibration bewegen sich nicht nur die Wafer, sondern auch die Abstandshalter oder "support pins" (dort 148) in lateraler Richtung, sind also nicht relativ zur Hauptplatte festgelegt. Damit kann eine Kratzvermeidung einhergehen, aber die genaue Positionierung der Wafer ist hier nur ungefähr möglich.

Die Erfindung hat es sich deshalb **zur Aufgabe gestellt,** flache Wafer schonender zu bearbeiten und nur diejenigen Flächenstücke des Wafers in der Einrichtung mit Plasma oder einem sonstigen Bearbeitungsverfahren durch Strahlung zu verändern, die tatsächlich gewollt sind, insbesondere unerwünschte Kratzbeschädigungen auf der nach unten (zur Elektrode) weisenden belichteten Oberfläche auszuschließen.

Gelöst wird diese Aufgabe mit Anspruch 1.

Die Erfindung geht dabei davon aus, daß die Wafer nicht auf die metallischen Platten als Gegenelektrode aufgelegt werden sollen, sondern im Abstand davon gehalten werden (Anspruch 1). Das Halten übernehmen (ruhende) Tragstücke, die in Mulden eingesetzt sind und dabei mehrere verteilt angeordnet Sockel bilden, auf denen die Wafer randseitig aufgelegt werden können. Auf einer Basisplatte, die eine Oberfläche hat, ist der Abstand der Auflageflächen von der Oberfläche der Basisplatte so bemessen, daß dieser Abstand deutlich unter der freien Weglänge des Plasmas liegt, im Bereich zwischen Vorvakuum bis Hochvakuum. Hier sind Drücke zwischen 10⁻¹ bis 10⁻² mbar angesprochen.

Die Tragstücke sind bevorzugt selbst-isolierend und vakuumfähig (Anspruch 5, 6). Sie halten dem Plasma stand, in der Regel bestehen sie aus Keramik oder Teflon. Sie haben eine Höhenerstreckung und eine laterale Erstreckung. Die Höhe kann funktionell so umschrieben werden, daß ein selbständig stehendes Tragstück, das in eine Mulde eingesetzt ist, nicht umfällt oder umkippt. Das Stützen durch eine jeweilige Mulde geschieht durch einen zumindest abschnittsweise ebenen Boden der Mulde, der eine entsprechende untere Flachseite des Rumpfes des Tragstücks stützt. Damit sind eingesetzte Tragstücke stationär oder ruhend, ohne für ihre Aufgabe lateral oder vertikal verschoben zu werden. Durch die standfeste Positionierung gegenüber der Gegenelektrode können die Tragstücke mit ihrer relativ breiten und flachen Auflagefläche eine kratzsichere Stützung und Lagerung der Wafer im Randbereich ermöglichen, auch an deren empfindlichen Oberflächenseite.

Es wird möglich, eine möglichst geringe freie Weglänge zwischen der nach unten weisenden Oberfläche des Wafers und der Gegenelektrode einzustellen, wenn die Tragstücke stationär und ruhend, also stabil an festen Stellen zu liegen kommen.

Die Flexibilität ist eine weitere Aufgabenstellung der Erfindung. Sie wird erreicht durch Anordnung von mehreren Mulden in der Oberfläche, zur Aufnahme von gleich ausgebildeten Tragstücken als Sockel. Jeweils eine Gruppe von Mulden ist einander zugeordnet und dient zur Aufnahme einer Wafergröße. Wir eine größere oder eine kleinere Wafergröße bearbeitet, kann eine andere Gruppe von Mulden mit Tragstücken belegt werden, um diese neue Größe von Wafern in vertikaler Richtung zu stützen, im Abstand von der Oberfläche der Basisplatte die als Gegenelektrode dient.

Die einzelnen Gruppen sind an die Größe der zu behandelnden Wafer angepaßt. Werden runde Wafer vorgesehen, können die Gruppen nach Art von Fahrstrahlen geordnet sein, wobei für einen Wafer auf jedem in radial unterschiedlicher Richtung laufenden Fahrstrahl eine Mulde aus einer Gruppe als Platz für das Einlegen einer Traganordnung verwendbar ist. Eine Mulde aus jeder Gruppe der vorgesehenen, zumeist drei, Fahrstrahlen ist Bestandteil der geometrischen Tragvorrichtung, zum Stützen eines Wafers gegebener Größe (Anspruch 4).

Im Zentrum kann zusätzlich eine Mulde vorgesehen sein, zur Aufnahme eines in Höhenrichtung geringeren Tragstücks, das als Sicherheitsfunktion eine Höhe nur aufweist, die zwischen der Unterseite des Wafers und der Oberfläche der Basisplatte liegt (Anspruch 15). Dadurch kann ein Durchhängen des Wafers vermieden werden, auch bei stärkerer Belastung und bei größerem Abstand der die Wafer außen an ihrem Rand haltenden übrigen Tragstücke.

Die Mulden sind so ausgebildet, daß die Tragstücke in ihnen aufgenommen werden können. Es empfiehlt sich zumeist eine runde Form für die Mulden, so daß auch runde Tragstücke in die Mulden eingesetzt werden können (Anspruch 10, Anspruch 11).

Zwingend ist diese runde Gestaltung aber nicht, ebenso können rechteckige Tragstücke verwendet werden, mit dann formgerecht angepaßten Mulden.

Oberhalb der Basisplatte (als Elektrode) ist der Behandlungsraum vorgesehen, in dem das Plasma wirksam ist. Die hier vorgesehene Strahlung trifft vertikal auf die flächig angeordneten Wafer auf und bearbeitet die Oberfläche, die dem Plasma ausgesetzt wird. Es findet eine flächige Bearbeitung statt, aber nur eine punktförmige Abstützung der Wafer an den Tragstücken (als Sockel). Der Behandlungsraum ist aufgrund des vorgesehenen Plasmas evakuierbar, wofür bekannte, ein Vakuum herstellende Vorrichtungen im Zusammenhang mit der erfindungsgemäßen Bearbeitungsanordnung verwendet werden können.

Die Mulden sind zu den Tragstücken passend ausgebildet, um sie nur teilweise aufzunehmen. Die Mulden sind auch so angeordnet, daß sie an zumindest eine Form der zu behandelnden Wafer angepaßt sind. Das betrifft mehrere, insbesondere drei Mulden, die als eine Gruppe mehrere Tragstücke aufzunehmen vermögen, um insbesondere drei Auflagepunkte (im Sinne von kleinen Auflageflächenstücken) für die Unterseite des Wafers an ihrem Randabschnitt zu bilden. Vom diesem Anordnungsprinzip einer Traganordnung können mehrere auf einer Basisplatte vorgesehen sein. Ist die Basisplatte in den jeweils vorgesehenen geometrisch korrespondierenden Mulden mit den Tragstücken belegt, können die Wafer einer gegebenen Größe aufgelegt werden und die Basisplatte eingeschoben werden (Anspruch 19).

Mehrere solcher Platten sind übereinander anbringbar (Anspruch 18), wobei jede einzelne Basisplatte aus dem geöffneten Behandlungsraum heraus bewegbar ist, um Zugriff zu den darauf plazierten Wafern zu haben. Werden alle übereinander angeordneten Basisplatten eingeschoben, der Behandlungsraum über eine Tür geschlossen, so kann ein Vakuum aufgebaut werden und die Bearbeitung aller in dem Behandlungsraum übereinander und lateral verteilt befindlichen Wafer beginnen.

Jedes der umschriebenen Tragstücke besitzt einen Kopf und einen Rumpf. Der Kopf ist geeignet, die Lateralverschiebung der Wafer zu begrenzen, während der Rumpfabschnitt mit einer nach oben zeigenden Auflagefläche geeignet ist, in einem Teilabschnitt davon einen jeweiligen Wafer durch Berührung in einer festen vertikalen Lage zu halten. Der Kopfabschnitt ragt aber über die Oberfläche zum vertikalen Abstützen der Wafer hinaus. An der Unterseite ist ein flacher Boden des Tragstückes vorgesehen, der mit einem Aufnahmeboden der jeweiligen Ausnehmung in der Gegenelektrode stützend zusammenwirkt. In vertikaler Richtung sind die Tragstücke durch eine Boden/Boden-Berührung stationär gestützt. Lateral ist ein Kippen durch die Höhen/Breiten-Relation weitestgehend unmöglich.

Die Abstandsrelation der Köpfe einer Gruppe von eingesetzten Tragstücken ist so ausgebildet, daß der Wafer zwischen sie eingelegt werden kann und mit geringem Spiel von den zumindest drei Kopfabschnitten der zumindest drei Tragstücke lateral zumindest im wesentlichen fixiert wird. Geringe Verschiebungen sind zugelassen, solange das zugelassene Spiel nicht die laterale Erstreckung der vorgesehenen Auflageflächen der Rumpfabschnitte der Tragabschnitte verläßt. Ein übermäßiges laterales Verrutschen wird somit vermieden, wobei das Übermaß dadurch beschrieben wird, daß ein Randabschnitt eines Wafers, das einem Tragstück zugeordnet ist, über das Maß der hier zugeordneten Auflagefläche hinaus verrutscht wird.

Nachfolgend wird die Erfindung mit Beispielen anhand der Figuren näher erläutert.
- **Figur 1**: veranschaulicht im Ausschnitt einen Querschnitt durch eine Ebene einer Auflageplatte 30, in der ein Tragstück 20 angeordnet ist, das einen Wafer 10 randseitig trägt.
- **Figur 2a Figur 2b**: zeigen in Aufsicht zwei verschiedene Formen von Tragstücken 20,25.
- **Figur 3**: veranschaulicht in Aufsicht eine geometrische Anordnung von mehreren Gruppen von Aufnahmemulden, die nicht mit Tragstücken 20,25 belegt sind, bei denen aber zur Veranschaulichung ihrer räumlich geometrischen Anordnung zwei Wafergrößen 10,10' schematisch skizziert ist, die aufgelegt werden würden, wenn zuvor die anhand der Figuren 1, 2a, 2b gezeigten Tragstücke in die geometrisch passenden Mulden ruhend eingesetzt sind.
- **Figur 3a**: ist ein Ausschnitt des Zentrums 100 von Figur 3, hier im Ausschnitt und Querschnitt.
- **Figur 4**: ist eine Frontansicht eines geöffneten Behandlungsgerätes 1 mit Blick auf und in den Behandlungsraum 40.

**Figur 1** veranschaulicht einen Querschnitt durch eine plattenförmige Elektrode 30, in die eine Aufnahmemulde 31 mit einem im wesentlichen flachen Bodenabschnitt 31 a eingebracht ist. In der Aufnahmemulde ist ein Tragstück 20 angeordnet, das im Querschnitt aus einem Rumpf 22 und einem demgegenüber kleineren Kopf 21 ausgebildet ist. Die Oberfläche des Rumpfes 22 bildet eine Auflagefläche 20a, auf der ein Randabschnitt eines eingezeichneten Wafers 10 aufliegt. Der Wafer 10 hat durch die Auflage auf der Auflagefläche 20a mit seiner Unterseite 10u einen Abstand "a" von der Oberfläche 30a der Elektrode 30. Eingezeichnet ist schematisch ein reaktives Ionenätzen (RIE) durch Strahlung in einem Behandlungsraum 40, wobei die Strahlung von oben auf die Oberfläche des Wafers einwirkt.

Der Wafer hat einen lateralen Rand 10r, der einen geringen Abstand von einem Umriß 21a des Kopfes 21 aufweist.

Die Höhengeometrien und Höhenrelationen sollen im folgenden erläutert werden, wobei zuvor auf die Aufsicht in den **Figuren 2a und 2b** hingewiesen werden soll. Diese Figuren zeigen zwei Aufsichten von zwei möglichen Tragstücken 20, wobei die Figur 2a ein kreisrundes Tragstück mit einem (zylindrischen) runden Körper 22 und einem (zylindrischen) runden Kopf 21 zeigt. Die Oberfläche 20a ist die Differenz aus der Gesamtoberfläche des Rumpfes 22 und dem darin plazierten Kopfabschnitt 21, der somit einen effektiven verbleibenden Oberflächenbereich 20a beläßt. Bei einer viereckigen oder auch mehreckigen Ausgestaltung, insbesondere auch als Polygon, ergibt sich eine Aufsicht gemäß Figur 2b und ein Tragstück 25 mit einer entsprechend geformten Oberfläche 25a, bei einer ebenfalls vorgesehenen kreisrunden Gestaltung des (zylindrischen) Kopfes 21. Die laterale Erstreckung ist bei Tragstück 20 der Durchmesser c, bezogen auf den Rumpf. Bei Figur 2b ist die laterale Erstreckung mehreckig, hier ist das Quermaß b auch bezogen auf den Rumpf 25a des hier gezeigten Tragstücks 25. Beide Tragstücke weisen eine jeweilige Unterseite auf, die bei dem Tragstück 20 im Rumpfabschnitt 22 mit 22a in Figur 1 ersichtlich ist. Diese untere Fläche wirkt zusammen mit der Bodenfläche 31 a der Aufnahmemulde 31, so daß ein zumindest abschnittsweise flächiges Stützen möglich ist, ohne das die Tragstücke eine vertikale Bewegung ausüben.

Die Höhenrelation aus Figur 1 zeigt, daß der Kopf 21 eine Gesamthöhe zusammen mit dem Rumpf 22 von h2 besitzt. Die Aufnahmemulde 31 besitzt eine Tiefe m und die Höhe des Rumpfes 22 beträgt h1. Ist die Höhe h1 größer als die Tiefe m, ergibt sich eine Differenz a, entsprechend dem Abstand der Unterseite 10u des Wafers 10, bei Aufliegen auf der Fläche 20a. Die Höhe h2-h1 ergibt die Höhe des Kopfes 21. Er kann an die Waferdicke des Wafer 10 angepaßt sein, kann aber auch deutlich erhöht und geringfügig unterhalb der Waferdicke liegen, sollte aber zumindest eine solche Höhe aufweisen, daß der Wafer zwischen mehreren beabstandet vorgesehenen Köpfen 21 nur noch ein geringes Spiel besitzt und somit einigermaßen sicher fixiert zwischen mehreren beabstandeten Tragstücken zu liegen kommt, was an den übrigen Figuren erläutert werden soll.

**Figur 3** veranschaulicht dazu die Geometrie der Mulden, die in Gruppen auf Fahrstrahlen dargestellt sind. Ein Fahrstrahl r1 und ein zweiter Fahrstrahl r2 und ein dritter Fahrstrahl r3 zeigen in drei um 120° versetzte Winkelrichtungen, wobei auf einem jeweiligen Fahrstrahl drei Mulden in einem gegebenen Abstand so angeordnet sind, daß jeweils eine Mulde aus drei Fahrstrahlen zusammen eine Geometrie bilden, geeignet zur Stützung eines eingezeichneten Wafers 10. Ein alternativer (größerer) Wafer 10' ist eingezeichnet und verwendet andere Mulden zu Ablagezwecken. Eine jeweilige Gruppe von Mulden ist entlang eines Fahrstrahles angeordnet. Der Fahrstrahl r1 enthält die Mulden 31, eine weiter außen liegende Mulde 31a und eine weiter innen liegende Mulde 31 i. Gleiches gilt für die Mulde 32 auf Fahrstrahl r2, die weiter innen liegende Mulde 32i und die weiter außen liegende Mulde 32a. Selbiges gilt auch für die Mulde 33, deren weiter außen liegende Mulde 33a und deren weiter innen liegende Mulde 33i. Im Beispiel ist der Wafer 10 so eingezeichnet, daß er die Mulden 31,32 und 33 teilweise überdeckt. Werden Tragelemente gemäß Figuren 2 in die drei zuletzt genannten Mulden eingesetzt, liegt der Kopf 21 mit seiner Peripherie 21 a am Rand 10r des Wafers 10 im wesentlichen an, nur ein geringer Abstand ist hier vorgesehen, der nicht größer sein sollte, als der Bereich der Auflagefläche radial innerhalb von dem Umriß 21a. Die Mittelpunkte der Mulden sind gegenüber der Peripherie des Wafers also etwas nach außen versetzt, um eine geometrische Erstreckung des Kopfes 21 zu ermöglichen.

Ist ein größerer Wafer 10' vorgesehen, werden die äußeren Mulden 31a, 32a und 33a verwendet, auch jeweils durch Einsetzen der gleichen Tragstücke 20 von Figur 2a, wobei die zuvor genannten Tragstücke herausgenommen sind.

In der Mitte 100 (kennzeichnet die vertikale Symmetrieachse) ist eine zusätzliche Mulde 34 vorgesehen, die in **Figur 3a** näher erläutert ist. Dort nimmt sie ein flacheres Tragstück 26 auf, das noch einen Abstand von der Unterseite 10u des Wafers 10 besitzt, um nur dann berührend einzugreifen, wenn der Wafer durchbiegt, zu stark belastet wird oder aufgrund größerer Abstände der Stützmulden 31 a, 32a und 33a die Neigung zeigt, durchzubiegen. Erkennbar ist die Höhe h3, die geringer ist, als das Maß "a" von Figur 1. Ebenfalls erkennbar ist die Oberfläche 30a der Elektrode 30 sowie der Wafer 10 in einem Ausschnitt.

Die räumliche Geometrie der Figur 3 erbringt jeweils eine Stützanordnung, bestehend aus drei räumlich beabstandeten Tragstücken, die in Mulden eingesetzt sind. Diese Tragstücke, im gezeigten Beispiel eingesetzt in die Mulden 31, 32 und 33 ergeben eine Stützanordnung, auch Traganordnung genannt, die sowohl axial stützt, wie auch eine zu große laterale Verschiebung sperrt, orientiert an der Erstreckung der Köpfe 21 mit ihrer Peripherie 21a. Die Geometrie ist durch die Abstände d1, d2, d3 vorgegeben, die an den Mittelpunkten der Mulden orientiert ist, entsprechend den Mittelpunkten der Köpfe. Erwähnt war bereits, daß die Mulden gegenüber der Randabmessung des Wafers etwas nach außen verlagert sind, also ein größerer Anteil der Mulden außerhalb des Wafers liegt, als unterhalb des Wafers zu Stützungszwecken, veranlaßt durch die Erstreckung des Kopfes 21 mit seiner Peripherie 21a. Die Abmessungen sind demzufolge so orientiert, daß der Wafer zwischen diese Kopfstücke 21 der drei eingesetzten Tragstücke paßt. Wird ein größerer Wafer gewählt, werden andere beabstandete Mulden verwendet, um die Stützanordnung zu bilden.

Jeweils ein Tragelement aus einer Gruppe von auf einem Fahrstrahl angeordneten Tragstücken wird für eine Zusammenstellung einer Geometrie zu Stützzwecken verwendet.

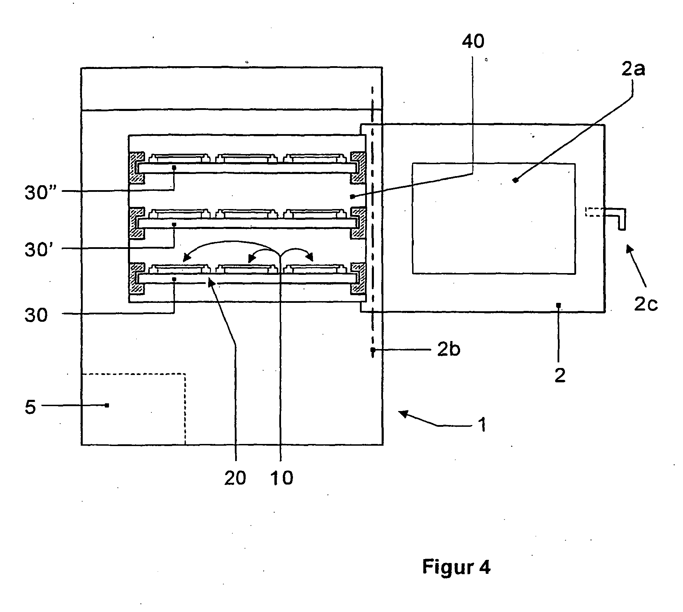

Der Behandlungsraum 40 aus Figur 1 ist schematisch in **Figur 4** anhand eines Gerätes dargestellt. Das Gerät besitzt eine Vakuumeinrichtung 5 und einen Behandlungsraum 40, der mit einer Tür 2 verschlossen werden kann. Die Tür kann eine Sichtscheibe 2a aufweisen und ist im geschlossenen Zustand vakuumdicht, so daß der Behandlungsraum 40 evakuiert werden kann und eine RIE-Strahlung von oberhalb ausgelöst werden kann. Die einzelnen Ebenen 30, 30' und 30" entsprechen der in Figur 1 dargestellten einen Ebene 30. Mehrere Wafer sind auf einer jeweiligen Basisplatte 30 verteilt angeordnet und können an Gleitschienen herausgeschoben werden, die randseitig in dem Behandlungsraum 40 angeordnet sind.

Ist die Behandlung abgeschlossen, wird die Tür 2 am Scharnier 2b geöffnet und die Wafer nach Herausziehen der Elektrodenlade nacheinander von den Tragstücken abgenommen.

Als Behandlung in der Kammer 40 können mehrere Möglichkeiten vorgesehen werden. Es können Lackschichten auf dem Wafer entfernt werden. Sie können verascht werden. Ebenfalls vorderseitig, wie rückseitig kann diese Behandlung geschehen. Wenn auf dem Wafer selektive Kontaktstellen aus Metall vorgesehen sind, können auch diese Metallstellen gereinigt werden.

Lacke, die für einen Prozeß als Zwischenstufe aufgetragen werden, um chemische Prozesse ablaufen oder selektiv ablaufen zu lassen, können in dieser Anordnung wieder entfernt werden. Aufgrund der vorgesehenen Tragstücke 20, die schematisch in der Figur 4 erkennbar sind, liegen die Wafer 10 nicht auf der Basisplatte 30, 30' und 30" auf. Sie haben einen Abstand a, wie an Figur 1 gezeigt, wobei Figur 1 nur die eine Tragstelle an der Mulde 31 zeigt und die übrigen Tragstellen der Figur 3 entsprechend ausgebildet sind, wie aus Figur 4 ersichtlich. Nicht eingezeichnet in Figur 4 sind die mittleren Zusatztragstücke 26 in der zentralen Mulde 34.

Die Tragstücke können aus Teflon oder Keramik gefertigt sein. Sie sollten plasmabeständig und vakuumfähig sein.

Eine andere Beschreibung der Figur 3 mit den drei gezeichneten Fahrstrahlen liegt in der Angabe von konzentrischen Kreisen, auf denen die Mulden angeordnet sind, wobei jeweils eine Mulde aus einer Gruppe (entlang eines Fahrstrahls) mit einer jeweiligen anderen Mulde auf den beiden anderen Fahrstrahlen geometrisch korrespondiert, um dem Wafer 10 angepaßt zu sein. Auf den konzentrischen Kreisen können die Mulden auch nicht entlang eines Fahrstrahls angeordnet sein, sondern versetzt gegeneinander, wenn sie bei Beachtung der Geometrie des Wafers zumindest an diesen geometrisch angepaßt sind, so daß im Randbereich dieses Wafers eine Stützfunktion möglich ist.

## Patentansprüche

1. **Behandlungsanordnung** zur Reinigung oder Veraschung von Oberflächen von zu behandelnden flachen Wafern (10), wobei
(a) in einem evakuierbaren Behandlungsraum (40) zumindest eine flächige Basisplatte (30) als Elektrode vorgesehen ist;
(b) in der Basisplatte (30) Mulden (31,32,33) so ausgebildet und verteilt angeordnet sind, daß sie zur Aufnahme von Tragstücken (20,25) geeignet sind und zumindest eine an eine Form eines zu behandelnden flachen Wafers (10) angepasste Anordnung oder Position besitzen; wobei jeder Boden (31 a) jeder Mulde zur zumindest abschnittsweisen Stützung eines jeweiligen Tragstücks (20;25) geeignet ist, und jedes aufgenommene Tragstück eine Höhe (h1,h2) aufweist, die geringer ist als seine laterale Erstreckung, und das Tragstück (20,25) eine Bodenfläche (22a) aufweist, die relativ zur Höhe (h2) des Tragstücks so bemessen ist, dass es bei dem zur Behandlung aufliegenden flachen Wafer eigenständig Halt gegen Umkippen oder Umfallen bietet;
wobei die Tragstücke (21,25) jeweils zumindest eine Auflagefläche (20a,25a) besitzen, deren Höhe (h1) nach einem Einsetzen in die jeweilige Mulde mit Boden auf einem Niveau (a) oberhalb der Basisplatte (30) zu liegen kommt, zumindest in einem Oberflächenbereich (30a) der Basisplatte (30), der bei auf den Tragstücken zur Behandlung aufgelegtem flachen Wafer (10) darunter angeordnet ist und
wobei die Tragstücke in lateraler Richtung an die laterale Muldenerstreckung (31,32,33) angepasst sind, um von der Mulde (31,31a) abschnittsweise ruhend aufgenommen zu werden.

2. Behandlungsanordnung nach Anspruch 1, wobei die Verteilung der Mulden (31,32,33) an die Form zumindest einer der flächigen Wafer (10) angepasst ist und zumindest drei Mulden (31,32,33) ein Abstandsmaß (d1,d2,d3) voneinander besitzen, das die Auflage des Wafers (10) auf mehrere, in die mehrere Mulden eingesetzte Tragstücke (20) erlaubt.

3. Behandlungsanordnung nach Anspruch 1, wobei von einem Zentrum (34,100) ausgehend in mehrere Richtungen (r1,r2,r3) weitere Mulden (31 a,31 i; 32a,32i) vorgesehen sind, deren Abstände zum Zentrum größer und/oder kleiner als die Abstände sind, welche die ersten Mulden (31 ;32) vom Zentrum aufweisen.

4. Behandlungsanordnung nach Anspruch 1, wobei mehrere Gruppen von Mulden vorgesehen sind (31a,31,31i; 32a,32,32i), die zur Aufnahme gleich ausgebildeter Tragstücke (20;25) geeignet sind und
(aa) jeweils eine Mulde (31) aus einer ersten Gruppe mit einer Mulde (32) aus einer zweiten Gruppe geometrisch korrespondiert, zur aufliegenden Aufnahme eines Wafers (10) mit einer gegebenen ersten Wafergröße;
(bb) eine andere Mulde (31a) aus der ersten Gruppe mit einer anderen Mulde (32a) aus der zweiten Gruppe korrespondiert, zur Auflage eines zweiten Wafers (10'), dessen Größe von der ersten Wafergröße abweicht.

5. Behandlungseinrichtung nach einem der vorigen Ansprüche, wobei die Tragstücke (20;21,22) aus Isolierwerkstoff gefertigt sind.

6. Behandlungseinrichtung nach Anspruch 5, wobei die Tragstücke (20) als ruhende Stücke vakuumfähig und/oder plasmabeständig sind.

7. Behandlungseinrichtung nach einem der vorigen Ansprüche, wobei die Tragstücke (20) einen Rumpf (22) und einen Kopf (21) aufweisen, wobei der Kopf (21) eine geringere laterale Erstreckung besitzt, als der Rumpf (22).

8. Behandlungseinrichtung nach Anspruch 7, wobei der nicht vom Kopf eingenommene Flächenanteil der Oberfläche (20a) des Rumpfes abschnittsweise als Auflagefläche für einen flächigen Wafer (10) dient.

9. Behandlungseinrichtung nach Anspruch 7, wobei die Höhenerstreckung (h2-h1) des Kopfes (21) im Wesentlichen an eine Dicke des flächigen Wafers angepasst ist.

10. Behandlungseinrichtung nach einem der vorigen Ansprüche, wobei das jeweilige Tragstück (20) zumindest in einem Rumpfabschnitt (22) rund ausgebildet ist.

11. Behandlungseinrichtung nach einem der vorigen Ansprüche, wobei das jeweilige Tragstück einen Kopfabschnitt (21) aufweist, der rund ausgebildet ist.

12. Behandlungseinrichtung nach einem der vorigen Ansprüche, wobei die Tragstücke (20) im Bereich ihrer Auflageflächen (20a) so ausgebildet sind, daß einem jeweiligen Wafer (10) ein lateraler Halt gegen Verrutschen gegeben wird und die Auflagefläche (20a) geeignet ist, dem Wafer einen vertikalen Halt oberhalb der Elektrode (30) zu geben.

13. Behandlungseinrichtung nach einem der vorigen Ansprüche zur Verwendung bei der Reinigung eines Wafers, bei der Entlackung eines Oberflächenanteils des Wafers, insbesondere durch Entfernen oder Veraschen einer Lackschicht, oder beim Reinigen von metallischen Anschlußkontakten auf dem Wafer.

14. Behandlungseinrichtung nach Anspruch 1, wobei die Vergleichshöhe (h1) beim Tragstück eine Höhe des Rumpfabschnitts (22) ist, oder das jeweilige Tragstück eine Gesamthöhe (h2) aufweist, die geringer ist als die laterale Erstreckung (c,d).

15. Behandlungseinrichtung nach einem der vorigen Ansprüche, wobei zwischen mehreren Mulden (31,32,33) eine weitere Mulde (34) vorgesehen ist, zur Aufnahme eines weiteren Isolierkörpers (26), dessen Höhenerstreckung (h3) zwischen der Unterseite des Wafers (10u) und der Oberseite (30a) der Basisplatte liegt.

16. Behandlungseinrichtung nach Anspruch 2, 3 oder 4, wobei die Verteilung der Mulden nach Art von konzentrischen Kreisen erfolgt, indem auf jedem der konzentrischen Kreise mehrere, insbesondere zumindest drei, Mulden zur Aufnahme von Tragstücken (20) vorgesehen sind, wobei jedem der konzentrischen Kreise eine von mehreren Wafergrößen (10,10') zugeordnet ist.

17. Behandlungseinrichtung nach Anspruch 4, wobei eine Gruppe von Mulden entlang eines Fahrstrahls (r1,r2) angeordnet ist, insbesondere in regelmäßigen Abständen oder an Standard-Durchmesser von verschiedenen Wafergrößen angepaßt.

18. Behandlungseinrichtung nach einem der vorigen Ansprüche, wobei mehrere Basisplatten (30) übereinander in einem Gerät (1) oder einer Plasmaanlage mit dem Behandlungsraum (40) und in dem Behandlungsraum angeordnet sind, insbesondere zum einzelnen und unabhängigen Herausziehen aus dem Behandlungsraum.

19. Behandlungseinrichtung nach Anspruch 18, wobei auf jeder Basisplatte mehrere Wafer auf Tragstücken (20) im Höhenabstand (a) von der Basisplatte (30,30a) gehalten sind.

## Claims

1. **Treatment arrangement** for cleaning or ashing surfaces of flat wafers (10) to be treated, wherein
(a) in a treatment chamber (40) which can be evacuated, at least one two-dimensional base plate (30) is provided as the electrode;
(b) in the base plate (30), troughs (31, 32, 33) are designed and arranged to be distributed so that they are suitable for receiving support pieces (20, 25) and have at least one arrangement or position adapted to the shape of a flat wafer (10) to be treated; wherein each base (31 a) of each trough is suitable for at least section-wise support of a particular support piece (20; 25), and each received support piece has a height (h1, h2) which is less than its lateral extension, and the support piece (20, 25) has a base surface (22a) which has dimensions relative to the height (h2) of the support piece so that it offers independent hold against tipping over or falling over for the flat wafer lying thereon for treatment;
wherein the support pieces (21, 25) have in each case at least one bearing surface (20a, 25a), the height (h1) of which comes to rest with base on a level (a) above the base plate (30) after insertion into the particular trough, at least in a surface region (30a) of the base plate (30), which, when the flat wafer (10) is placed on the support pieces for treatment, is arranged therebelow and wherein the support pieces in lateral direction are adapted to the lateral trough extension (31, 32, 33) to be received resting section-wise by the trough (31,31 a).

2. Treatment arrangement according to claim 1, wherein the distribution of the troughs (31, 32, 33) is adapted to the shape of at least one of the two-dimensional wafers (10) and at least three troughs (31, 32, 33) have a distance dimension (d1, d2, d3) from one another which permits the support of the wafer (10) on several support pieces (20) inserted into the several troughs.

3. Treatment arrangement according to claim 1, wherein starting from a centre (34, 100), further troughs (31 a, 31 i; 32a, 32i) are provided in several directions (r1, r2, r3), the distances of which from the centre are greater and/or less than the distances which the first troughs (31; 32) have from the centre.

4. Treatment arrangement according to claim 1, wherein several groups of troughs are provided (31 a, 31, 31 i; 32a, 32, 32i), which are suitable for receiving support pieces (20; 25) of the same design and
(aa) in each case a trough (31) from a first group corresponds geometrically to a trough (32) from a second group for resting receiving of a wafer (10) having a given first wafer size;
(bb) a further trough (31 a) from the first group corresponds to a further trough (32a) from the second group to support a second wafer (10'), the size of which deviates from the first wafer size.

5. Treatment device according to one of the previous claims, wherein the support pieces (20; 21, 22) are made from insulating material.

6. Treatment device according to claim 5, wherein the support pieces (20) as resting pieces are vacuum-resistant and/or plasma-resistant.

7. Treatment device according to one of the previous claims, wherein the support pieces (20) have a body (22) and a head (21), wherein the head (21) has a smaller lateral extension than the body (22).

8. Treatment device according to claim 7, wherein the surface portion of the surface (20a) of the body not occupied by the head serves section-wise as a bearing surface for a two-dimensional wafer (10).

9. Treatment device according to claim 7, wherein the height extension (h2-h1) of the head (21) is adapted essentially to a thickness of the two-dimensional wafer.

10. Treatment device according to one of the previous claims, wherein the particular support piece (20) is designed to be round at least in a body section (22).

11. Treatment device according to one of the previous claims, wherein the particular support piece has a head section (21) which is designed to be round.

12. Treatment device according to one of the previous claims, wherein the support pieces (20) are designed in the region of their bearing surfaces (20a) so that a lateral hold against slipping is given to a particular wafer (10) and the bearing surface (20a) is suitable to give the wafer a vertical hold above the electrode (30).

13. Treatment device according to one of the previous claims for use when cleaning a wafer, when stripping a surface portion of the wafer, in particular by removing or ashing a lacquer layer, or when cleaning metallic connection contacts on the wafer.

14. Treatment device according to claim 1, wherein the comparative height (h1) for the support piece is one height of the body section (22), or the particular support piece has an overall height (h2) which is less than the lateral extension (c, d).

15. Treatment device according to one of the previous claims, wherein a further trough (34) is provided between several troughs (31, 32, 33) to receive a further insulating body (26), the height extension (h3) of which lies between the underside of the wafer (10u) and the upper side (30a) of the base plate.

16. Treatment device according to claim 2, 3 or 4, wherein the distribution of the troughs is effected like concentric circles, in that several, in particular at least three, troughs are provided on each of the concentric circles to receive support pieces (20), wherein one of several wafer sizes (10, 10') is assigned to each of the concentric circles.

17. Treatment device according to claim 4, wherein one group of troughs is arranged along a radius vector (r1, r2), in particular at regular distances or adapted to standard diameters of various wafer sizes.

18. Treatment device according to one of the previous claims, wherein several base plates (30) are arranged one above another in an apparatus (1) or a plasma plant with the treatment chamber (40) and in the treatment chamber, in particular for individual and independent removal from the treatment chamber.

19. Treatment device according to claim 18, wherein on each base plate, several wafers are mounted on support pieces (20) at height distance (a) from the base plate (30, 30a).

## Revendications

1. Dispositif de traitement pour le nettoyage ou le brûlage des surfaces de tranches (10) plates à traiter, dans lequel
(a) dans une chambre de traitement (40) pouvant être mise sous vide, au moins une plaque de base (30) plane est prévue à titre d'électrode ;
(b) dans la plaque de base (30), des coques (31, 32, 33) sont formées et réparties de manière à être appropriées pour la réception de pièces supports (20, 25) et à posséder au moins une disposition ou une position adaptée à une forme des tranches (10) plates à traiter ; où chaque fond (31a) de chaque coque est approprié à supporter au moins par tronçon une pièce support respective (20 ; 25) et chaque pièce support réceptionnée présente une hauteur (hl, h2) qui est plus faible que son extension latérale et la pièce support (20 ; 25) présente une surface de fond (22a) qui est dimensionnée par rapport à la hauteur (h2) de la pièce support de manière à offrir par elle-même une sécurité vis-à-vis du retournement ou de la chute pour la tranche plate résidente pour le traitement ;
dans lequel les pièces supports (21, 25) possèdent respectivement au moins une surface d'appui (20a, 25a) dont la hauteur (h1), après une insertion dans la coque respective, arrive à reposer avec le fond sur un niveau (a) situé au dessus de la plaque de base (30), au moins dans une zone de la surface (30a) de la plaque de base (30), qui est disposée en dessous pour la tranche (10) plate posée sur les pièces supports pour le traitement, et dans lequel les pièces supports sont adaptées, dans la direction latérale, à l'extension latérale des coques (31, 32, 33) pour être réceptionnées par la coque (31, 31a), posées, par tronçon.

2. Dispositif de traitement selon la revendication 1, dans lequel la répartition des coques (31, 32, 33) est adaptée à la forme d'au moins une des tranches (10) plates, et au moins trois coques (31, 32, 33) possèdent une distance (dl, d2, d3) qui les sépare qui permet l'appui de la tranche (10) sur plusieurs pièces supports (20) insérées dans plusieurs coques.

3. Dispositif de traitement selon la revendication 1, dans lequel on prévoit, en partant d'un centre (34, 100) dans plusieurs directions (r1, r2, r3), d'autres coques (31a, 31i ; 32a, 32i), dont les distances au centre sont supérieures et/ou inférieures aux distances qui séparent les premières coques (31 ; 32) du centre.

4. Dispositif de traitement selon la revendication 1, dans lequel on prévoit plusieurs groupes de coques (31a, 31, 31i ; 32a, 32, 32i) qui sont appropriés pour la réception de pièces supports (20 ; 25) conçues à l'identique et
(aa) respectivement une coque (31) provenant d'un premier groupe correspond géométriquement à une coque (32) provenant d'un deuxième groupe, pour la réception résidente d'une tranche (10) ayant une première taille donnée de tranche ;
(bb) une autre coque (31a) provenant du premier groupe correspond à une autre coque (32a) provenant du deuxième groupe, pour l'appui d'une deuxième tranche (10') dont la taille diverge de la première taille de tranche.

5. Dispositif de traitement selon l'une des revendications précédentes, dans lequel les pièces supports (20 ; 21, 22) sont fabriquées en matériau isolant.

6. Dispositif de traitement selon la revendication 5, dans lequel les pièces supports (20), en tant que pièces posées, sont susceptibles de résister au vide et/ou au plasma.

7. Dispositif de traitement selon l'une des revendications précédentes, dans lequel les pièces supports (20) présentent un tronc (22) et une tête (21), la tête (21) possédant une extension latérale plus faible que le tronc (22).

8. Dispositif de traitement selon la revendication 7, dans lequel la partie de l'aire de la surface (20a) du tronc, qui n'est pas prise par la tête, sert de surface d'appui pour une tranche (10) plane par tronçon.

9. Dispositif de traitement selon la revendication 7, dans lequel l'extension en hauteur (h2-h1) de la tête (21) est sensiblement adaptée à une épaisseur de la tranche plane.

10. Dispositif de traitement selon l'une des revendications précédentes, dans lequel la pièce support (20) respective est formée circulairement au moins dans une section du tronc (22).

11. Dispositif de traitement selon l'une des revendications précédentes, dans lequel la pièce support respective présente une section de tête (21), qui a une forme circulaire.

12. Dispositif de traitement selon l'une des revendications précédentes, dans lequel les pièces supports (20) sont conçues dans la zone de leurs surfaces d'appui (20a) de manière à fournir à chaque tranche (10) une sécurité latérale contre le glissement et de manière à ce que la surface d'appui (20a) soit appropriée à fournir une sécurité verticale à la tranche au-dessus de l'électrode (30).

13. Dispositif de traitement selon l'une des revendications précédentes, destiné à l'utilisation lors du nettoyage d'une tranche, lors du délaquage d'une partie superficielle de la tranche, notamment par élimination ou brûlage d'une couche de laque ou lors du nettoyage des contacts de connexion métalliques sur la tranche.

14. Dispositif de traitement selon la revendication 1, dans lequel la hauteur comparative (h1) pour la pièce support est une hauteur de la section du tronc (22) ou la pièce support respective présente une hauteur totale (h2) qui est plus faible que l'extension latérale (c, d).

15. Dispositif de traitement selon l'une des revendications précédentes, dans lequel une autre coque (34) est prévue entre plusieurs coques (31, 32, 33), destinée à la réception d'un autre corps isolant (26), dont l'extension en hauteur (h3) réside entre la face inférieure de la tranche (10u) et la face supérieure (30a) de la plaque de base.

16. Dispositif de traitement selon la revendication 2, 3 ou 4, dans lequel la répartition des coques s'effectue à la manière de cercles concentriques, en ce que, sur chacun des cercles concentriques, plusieurs, notamment, au moins trois, coques sont prévues pour la réception des pièces supports (20), où une parmi plusieurs tailles de tranche (10, 10') est affectée à chacun des cercles concentriques.

17. Dispositif de traitement d'après la revendication 4, dans lequel un groupe de coques est disposé le long d'un trajet (r1, r2), notamment à des intervalles réguliers ou bien est adapté à un diamètre standard de plusieurs tailles de tranche.

18. Dispositif de traitement selon l'une des revendications précédentes, dans lequel plusieurs plaques de base (30) sont disposées l'une sur l'autre dans un appareil (1) ou dans une installation plasma avec la chambre de traitement (40) et dans la chambre de traitement, notamment pour le retrait individuel et indépendant hors de la chambre de traitement.

19. Dispositif de traitement selon la revendication 18, dans lequel, sur chaque plaque de base, plusieurs tranches sont maintenues sur des pièces supports (20) à une distance en hauteur (a) de la plaque de base (30, 30a).
